# FASCICULE DE BREVET EUROPEEN

(11) **EP 4 409 246 B1**
(45) Date de publication et mention de la délivrance du brevet: **14.05.2025**
(21) Numéro de dépôt: 22797413.6
(22) Date de dépôt: 29.09.2022
(51) Int. Cl.: G01K 7/02, H01L 23/34

(54) **THERMOCOUPLE FIN COMPACT ET PROCÉDÉ DE FABRICATION D'UN TEL THERMOCOUPLE**
DÜNNES KOMPAKTES THERMOELEMENT UND VERFAHREN ZUR HERSTELLUNG EINES SOLCHEN THERMOELEMENTS
THIN COMPACT THERMOCOUPLE AND METHOD FOR MANUFACTURING SUCH A THERMOCOUPLE

(30) Priorité: 29.09.2021 FR 2110277
(43) Date de publication de la demande: 07.08.2024
(73) Titulaire: SAFRAN, 75015 Paris (FR)
(72) Inventeur: GEAGEA, Maya, 77550 MOISSY-CRAMAYEL (FR); STASINOPOULOS, Ioannis, 77550 MOISSY-CRAMAYEL (FR)
(74) Mandataire: Regimbeau
(86) Numéro de dépôt international: PCT/FR2022/051839
(87) Numéro de publication internationale: WO 2023/052729

(56) Documents cités:
- JP-A- S5 810 874
- US-B2- 7 648 269

## Description

### DOMAINE TECHNIQUE

L'invention concerne un thermocouple imprimé ainsi que son procédé de fabrication et trouve application notamment dans l'aéronautique pour mesurer des températures dans des parties confinées des équipements aéronautiques, notamment des moteurs.

Elle trouve aussi application dans le domaine de la micro-électronique pour sonder la température d'une puce d'un circuit intégré afin d'optimiser son refroidissement, monitorer sa performance et éviter son endommagement par surchauffe. Le positionnement du point de mesure doit être très précis et la taille du point de mesure très petit, vu la taille très petite de la puce.

### ETAT DE LA TECHNIQUE

Les thermocouples sont des sondes utilisées afin de mesurer la température. Ces sondes de température ont un large champ d'applications industrielles et scientifiques pour la gamme de température qui varie des températures très froides (par exemple aux alentours de -270°C) à des températures très chaudes (par exemple aux alentours de 2300°C). De tels thermocouples sont par exemple utilisés en aéronautique.

La conception typique d'un thermocouple consiste en deux matériaux métalliques conducteurs de natures différentes c'est-à-dire avec des propriétés thermiques et électriques différentes. Les deux métaux sont en contact au niveau d'une extrémité formant une « jonction chaude ». Cette jonction chaude représente le point de prise de la mesure.

Dans la plupart des cas d'application aujourd'hui des thermocouples filaires sont utilisés. La jonction chaude représente alors simplement une soudure des deux fils. Or les thermocouples filaires sont encombrants et perturbent le flux dans les équipements aéronautique notamment lorsqu'ils sont intégrés dans un moteur d'aéronef en contact avec le flux circulant dans le moteur, les performances du moteur étant dégradées de même ainsi que l'environnement à sonder.

Pour améliorer l'intégration des thermocouples, plus récemment des thermocouples fins ont été développés et présentent une géométrie bidimensionnelle (c'est-à-dire avec une faible épaisseur de l'ordre de quelques centaines de nanomètres à quelques dizaines de micromètres). Il est fait référence dans ce contexte aux thermocouples fins présentés dans les documents de l'état de la technique JP S58 10874 A et US 7 648 269 B2. Ces thermocouples fins sont plus faciles d'intégration. Ils sont compatibles avec les méthodes de nano et micro fabrication ou de dépôt, mises en œuvre dans l'industrie électronique et aéronautique, respectivement. Ils permettent ainsi de concevoir des composants intégrant des fonctions de mesure - et donc de monitoring d'état de santé - dès la fabrication

Dans ces thermocouples fins la jonction chaude est matérialisée par la superposition de dépôts de différences couches, est reliée à des bornes de connexion par les bras du thermocouple, le tout restant quasi bidimensionnel, les bornes de connexion étant reliées à ce qu'on nomme la « jonction froide ». En effet, Le principe de fonctionnement du thermocouple est basé sur l'effet Seebeck. Cet effet indique que lorsqu'on-un gradient de température apparaît entre la jonction chaude et la jonction froide du thermocouple, ceci génère une tension thermoélectrique. Cette tension ainsi mesurée permet d'obtenir la température au niveau de la jonction chaude.

Un problème avec les architectures de thermocouples fins est qu'elles sont encore trop encombrantes et occupent une grande surface.

### EXPOSE DE L'INVENTION

L'invention propose de diminuer l'encombrement d'un thermocouple.

A cet effet, l'invention propose un thermocouple selon la revendication 1.

L'invention concerne également un procédé de fabrication d'un thermocouple selon la revendication 7.

L'invention concerne également un dispositif de mesure de la température d'une aube de turbomachine, comprenant un thermocouple selon l'invention, le substrat étant disposé sur l'aube.

L'invention concerne également un dispositif de mesure de la température d'une zone déterminée d'un circuit électronique, comprenant un thermocouple selon l'invention, le thermocouple étant agencé dans la zone déterminée de manière à ce que la jonction chaude soit disposée sur la zone déterminée.

Contrairement aux structure connues, l'invention utilise une superposition en trois dimensions et pas un simple agencement dans un plan qui contrairement aux architectures connues considèrent le thermocouple comme une jonction ponctuelle de deux matériaux différents, et des fils ou pistes d'interconnexion : les éléments du thermocouple sont agencés autant dans le plan que hors du plan du substrat.

La structure proposée pour le thermocouple est compacte par l'empilement des bras du thermocouple en rapprochant les zones d'interconnexions pour être plus compact. Toutefois, les zones d'interconnexion peuvent être éloignées à volonté par rapport à la jonction chaude cette dernière étant toutefois compacte.

En outre, le thermocouple de l'invention est plus solide. En effet, dans le cas de l'architecture classique des thermocouples, les deux métaux ne se croisent qu'à un emplacement de taille très limité et rend la jonction chaude vulnérable aux dommages (érosion, chocs, etc.).

L'invention permet de diminuer la surface occupée par le thermocouple. Le thermocouple assure à la fois une surface occupée minimale, en maximisant en même temps la surface de la jonction chaude, ce qui amène de la redondance : une destruction partielle, telle qu'une griffe aura moins de chances de compromettre la performance du thermocouple.

Par conséquent, l'invention permet de mesurer des températures dans des parties confinées des équipements aéronautiques, notamment des moteurs, où une la mesure doit être le moins intrusive possible, car il faut minimiser la perturbation aérodynamique du flux.

### PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :
- la figure 1 illustre une vue de côté d'un thermocouple selon un premier mode de réalisation non conforme à l'invention ;
- la figure 2 et la figure 3 illustrent une vue de côté d'un thermocouple selon un deuxième mode de réalisation non conforme à l'invention ;
- la figure 4 illustre une vue de côté d'un thermocouple selon un troisième mode de réalisation selon l'invention avec des cotes identifiées ;
- la figure 5 illustre une vue de côté d'un thermocouple selon un quatrième mode de réalisation de l'invention ;
- la figure 6 illustre une vue de côté d'un thermocouple selon un cinquième mode de réalisation de l'invention ;
- la figure 7 illustre des étapes d'un procédé de fabrication d'un thermocouple selon une mode de réalisation de l'invention ;
- la figure 8 illustre des étapes d'un procédé de fabrication d'un thermocouple selon un mode de réalisation de l'invention ;
- la figure 9, la figure 10, la figure 11 et la figure 12 illustrent un thermocouple non conform à l'invention avec des bornes de connexion selon diverses configurations ;
- la figure 13 illustre l'intégration d'un thermocouple selon l'invention.

Sur l'ensemble des figures les éléments similaires portent des références identiques.

### DESCRIPTION DETAILLEE

### Structure générale d'un thermocouple selon l'invention

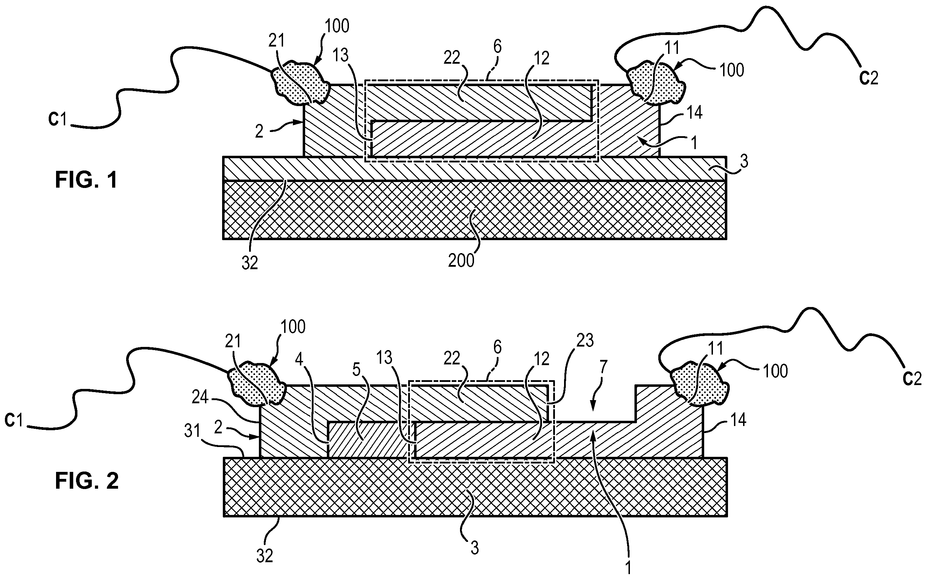

Les **figures 1** à **6** illustrent chacune un thermocouple selon différents modes de réalisation.

Le thermocouple selon l'invention comprend un premier bras 1 et un deuxième bras 2 disposés sur un substrat 3, le deuxième bras 2 recouvrant au moins partiellement le premier bras 1.

Le premier bras 1 et le deuxième bras 2 sont dans des matériaux différents et le substrat 3 est dans un matériau électriquement isolant.

Le substrat 3 est impérativement électriquement isolant afin d'éviter un court-circuit qui perturberait la mesure. Il peut être un revêtement de barrière thermique en zircone yttrié, mono- ou disilicate d'yttrium ou d'yterbium, alumine, couche d'oxyde d'un superalliage, ou tout autre diélectrique

Le substrat 3 comprend une face supérieure 31 et une face inférieure 32 opposées et parallèles entre elles.

Le substrat est destiné à être disposé sur un support tel qu'une pièce aéronautique ou un circuit électronique.

Le thermocouple peut en effet servir à mesurer la température qui règne dans des aubes de turbomachine. Dans cas, le substrat 3 est disposé sur un support 200 qui est une aube de turbomachine qui est en métal et donc électriquement conductrice. Le substrat 3 peut soit être rapporté et constitue une surcouche de quelques dizaines de microns soit être constitué par l'oxydation directe de la surface de l'aube 200.

De manière alternative, le thermocouple peut servir à mesurer la température dans un circuit électronique dans un point très précis du composant. Le support 200 étant alors formé par une surface d'un semi-conducteur ou d'un diélectrique type Rogers.

Ainsi, comme on le comprend, le substrat 3 peut prendre plusieurs types de formes qui dépendent de l'application faite du thermocouple et notamment le support sur lequel il est disposé.

Les premier et deuxième bras 1, 2 sont avantageusement constitués de pistes électriquement conductrices fines déposées sur le substrat 3.

Par exemple, le couple premier bras 1/deuxième bras 2 est choisi dans le groupe suivant Pt/Pt-Rh ; Ni-Cr/Ni-Al ; Cu/Cu-Ni ; Fe/Cu-Ni ; Ni-Cr/Cu-Ni ; Ni-Cr-Si/Ni-Si.

De manière plus générale, l'homme du métier saura choisir la combinaison de matériaux appropriée parmi celles connues dans l'état de l'art, afin de répondre au besoin de mesure de température, en fonction de la plage de températures et de la précision désirée.

Le premier bras 1 comprend une première borne de connexion 11 et le deuxième bras 2 comprend une deuxième borne de connexion 21 qui sont opposées au-dessus du substrat 3.

C'est aux bornes de connexion 11, 22 que des éléments (des fils par exemple) de connexion C1, C2 pour récupérer la mesure sont connectés, ces fils ici connectent le thermocouple à des plots de contact (non visibles ici). Ces éléments de connexion C1, C2 sont en particulier collés aux bornes de connexion 11, 21 au moyen d'une colle 100 (type pate conductrice à base d'argent) ou par soudage. L'objectif est de prévoir un élément conducteur pour assurer une telle connexion.

Le premier bras 1 comprend une première partie horizontale 12 disposée et en contact sur la face supérieure 31 du substrat 3 et la première borne de connexion 11 qui est ici de préférence une partie verticale perpendiculaire qui s'étend depuis une extrémité externe 14 de la première partie horizontale 12. Le premier bras 1 comprend une extrémité interne 13 qui débouche vers l'intérieur de la face supérieure 31 du substrat 3 et l'extrémité externe 14 depuis laquelle s'étend la première borne de connexion 11.

Le deuxième bras 2 présente une structure identique à celle du premier bras 1 mais est disposé sur le substrat 3 différemment du premier bras 1. À ce titre, le deuxième bras 2 comprend une deuxième partie horizontale 22 en contact avec la première partie horizontale du premier bras 1. En particulier, la deuxième partie horizontale 22 du deuxième bras 2 est en contact avec la première partie horizontale 12 du premier bras 1, les parties horizontales se recouvrant soit partiellement soit complètement. La deuxième borne de connexion 21 ici aussi qui s'étend verticalement et perpendiculairement depuis la partie horizontale 22 est disposée sur la face supérieure 31 du substrat 3 et la deuxième partie horizontale 22 s'étend depuis la deuxième borne de connexion 21 vers l'intérieur de la face de la première partie horizontale 12.

On décrit ici les première et deuxième bornes de connexion comme s'étendant perpendiculairement depuis chaque première et deuxième parties horizontales mais ce n'est pas obligatoire et cela dépend du type de connexion du thermocouple.

La zone contact entre le premier bras 1 et le deuxième bras 2 permet de définir une « jonction chaude » 6. En particulier, c'est la zone de contact entre la première partie horizontale 12 du premier bras 1 et la deuxième partie horizontale 22 du deuxième bras 2 qui définit la jonction chaude.

La jonction froide est située à distance de la structure du thermocouple et est définit par les éléments de connexion C1, C2, la mesure étant faite entre les deux éléments de connexion C1, C2.

Le deuxième bras 2 comprend une extrémité interne 23 qui débouche vers l'intérieur de la face supérieure 31 du substrat 3 sur la première partie horizontale 12 du premier bras 1 et une extrémité externe 24 depuis laquelle s'étend la deuxième borne de connexion 21.

Ainsi, toute la première partie horizontale 12 du premier bras 1 est en contact avec la face supérieure 31 du substrat 3 tandis que pour le deuxième bras 2 seule la deuxième borne de connexion 21 est en contact avec la face supérieure 31 du substrat 3.

Les premier et deuxième bras 1, 2 sont ainsi de préférence tous les deux en forme de L agencés l'un par rapport à l'autre de sorte que leur partie horizontale 12, 22 se recouvrent au moins partiellement en fonction de la dimension que l'on veut donner à la jonction chaude.

On décrit ci-après différents modes de réalisation découlant de la présentation générale ainsi faite.

### Premier mode de réalisation

La **figure 1** illustre une vue de côté d'un thermocouple selon un premier mode de réalisation non conforme à l'invention.

Selon ce premier mode de réalisation le premier bras 1 et le deuxième bras 2 se recouvrent complètement. En particulier, la première partie horizontale 12 du premier bras 1 recouvre complètement la deuxième partie horizontale 22 du deuxième bras 2. Ainsi, l'ensemble du thermocouple y compris les points de contacts et une partie des fils sont exposés au même champ thermique qu'on considère homogène. La soudure froide est reportée plus loin et les deux bras peuvent se toucher sur plusieurs surfaces.

Une application ici est de disposer le thermocouple sur une aube 200 d'une turbomachine, la jonction chaude étant maximisée et la jonction froide est éloignée.

La jonction chaude est donc sur l'aube à l'endroit du champ thermique et la jonction froide, est reportée plus loin en dehors du champ thermique et peut s'éloigner du champ jusqu'aux extrémités de l'aube. La maximisation de la jonction chaude permet de garantir la mesure de la température dans ce champ thermique considéré homogène, et d'être le plus précis possible dans la prise de mesure dans le champ thermique en question

### Deuxième mode de réalisation

La **figure 2** illustre une vue de côté d'un thermocouple selon un deuxième mode de réalisation non conforme à l'invention.

Selon ce deuxième mode de réalisation, le premier bras 1 et le deuxième bras 2 se recouvrent partiellement de manière à définir un premier espace libre 4 entre le substrat 3, le deuxième bras 2 et le premier bras 1. En particulier, la deuxième partie horizontale 22 du deuxième bras 2 recouvre partiellement la première partie horizontale 12 du premier bras 1.

Le premier espace libre 4 permet la connexion électrique indépendante de chaque bras et permet de définir la zone de « jonction chaude » 6 du thermocouple.

Le deuxième bras 2 comprend ainsi une deuxième partie horizontale 22 ici suspendue au-dessus de la face supérieure 31 du substrat 3 mais en contact partiel avec le premier bras 1.

Le premier espace libre 4 est défini par la deuxième borne de connexion 21 et les première et deuxième partie horizontales 12, 22 des bras 1, 2.

La zone de chevauchement des bras 1, 2 constituent la jonction chaude 6 et est repérée sur la figure 2 par un rectangle central : c'est la zone de recouvrement des bras 1, 2.

De manière avantageuse, le premier espace libre 4 est rempli d'un matériau diélectrique 5 qui est électriquement isolant dans la plage de fonctionnement souhaitée du thermocouple. Comme on peut le constater, le matériau diélectrique 5 est disposé au-dessous du deuxième bras 2 afin d'assurer la séparation électrique de la jonction chaude.

Prévoir un tel premier espace libre 4 permet d'isoler électriquement les bras 1, 2. Le remplir de diélectrique 5 augmente cette isolation. En outre, cela évite de laisser un « trou » vide dans la structure du thermocouple nuisible à sa stabilité mécanique. Le deuxième bras 2 n'est donc pas en suspension. De plus, un vide peut causer une accumulation d'eau ou d'autres éléments gênants, qui par exemple corroderait les bras, ou causeraient un court-circuit non-désiré entre les bras.

Selon ce deuxième mode de réalisation et par construction, la première partie horizontale 12 de premier bras 1 et la deuxième partie horizontale 22 du deuxième bras 2 se superposent partiellement au-dessus du substrat 3 de manière à laisser un deuxième espace libre 7 entre les deux bras 1, 2.

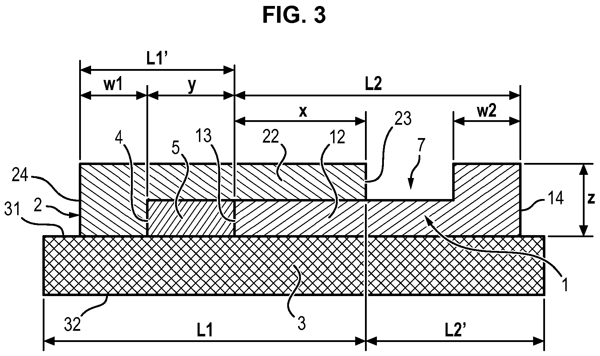

La **figure 3** illustre le thermocouple selon le deuxième mode de réalisation avec différentes cotes. La longueur x correspond à la longueur de la jonction chaude vue de côté. Cette longueur x est au minimum de l'ordre de quelques dizaines de nanomètres lorsque le thermocouple est disposé sur un circuit électronique ou au minimum de l'ordre du micron lorsque le thermocouple est disposé sur une aube de de turbomachine. Dans le cadre de la microélectronique, les composants tels qu'un transistor peuvent atteindre une dimension très faible de l'ordre d'une dizaine de nm, dans ce cas x est donc de l'ordre de la taille d'un transistor sur un circuit électronique. En revanche, x peut être plus grand si on veut sonder une température sous un ensemble de transistors qui forment une puce électronique

Lorsqu'il s'agit de sonde la température à un endroit d'une aube de turbomachine, x est au minimum de l'ordre la taille des grains métalliques des matériaux de superalliage formant l'aube. Ainsi, x est typiquement supérieure à 1µm

Les largeurs w1, w2 des première et deuxième bornes 11, 21 de connexion doivent être minimisées tout en étant suffisamment larges pour permettre une bonne connexion par collage ou soudure des fils de connexion. De telles largeurs w1, w2 sont à optimiser avec la largeur y du premier espace libre 4 rempli de diélectrique. Lorsque les premier et deuxième bras 1, 2 sont des pistes conductrices fines (c'est-à-dire de quelques nanomètres), *w1, w2* peuvent être de l'ordre de quelques dizaines de nanomètres (dans le cas de dépôts connus dans l'industrie du semi-conducteur, comme lithographiques) ou de l'ordre de quelques dizaines de micromètres dans le cas de dépôts à base de méthodes d'impression comme la sérigraphie, le jet d'encre, l'aérosol jet, la micro extrusion....

Dans le cas de figure d'une soudure par câble par fils (en anglais, wire-bonding) moyennant un fil ou soudure par le biais d'une colle, les bornes de connexion peuvent être de l'ordre de quelques dizaines de µm tels que le diamètre des fils de connexion qui vont être soudés ou collés par-dessus. A titre d'exemple un fil de platine peut-être de l'ordre de 60µm. Dans le cas de figure où on s'affranchit de l'étape de collage ou d'une soudure d'un fil et on vient rejoindre la connectique du circuit électronique, w1 et w2 dans ce mode de réalisation sont proportionnelles à z c'est-à-dire 2*z, 3*z, etc.

Les longueurs L1, L2 (prise en vue de côté) des premier et deuxième bras 1, 2 sont telles qu'elles assurent suffisamment de contact pour établir la jonction chaude mais suffisamment courtes pour compacter l'ensemble ou bien suffisamment longues pour rapporter les points d'interconnexion assez loin en fonction de l'intégration du thermocouple.

Les longueurs L1'=L1-x et L₂'=L2-x peuvent aller jusqu'à plusieurs millimètres de longueur (de 1mm à atteindre la plus longue dimension de la pièce qui peut être de préférence une aube (une aube de turbomachine peut aller jusqu'à 600mm), afin de rapporter le point de connexion loin de la jonction chaude.

La hauteur z de la première borne de connexion 11 doit être minimale pour éviter la perturbation du flux aérodynamique ou tout simplement pour compactifier le thermocouple, surtout si celui-ci fait partie d'un circuit microélectronique. La hauteur z peut varier entre quelques dizaines de nanomètres dans le cas d'applications dans la microélectronique (fabrication alors par lithographie et dépôts PVD, CVD) et quelques µm ou dizaines de microns pour des applications aéronautiques en utilisant des procédés d'impression cités plus haut.

En effet, l'épaisseur hors plan du substrat 3 pour des applications dans l'aéronautique notamment lorsque le thermocouple est disposé sur une aube d'une turbomachine doit être inférieure à 50µm afin de ne pas perturber le flux aérodynamique

### Troisième mode de réalisation

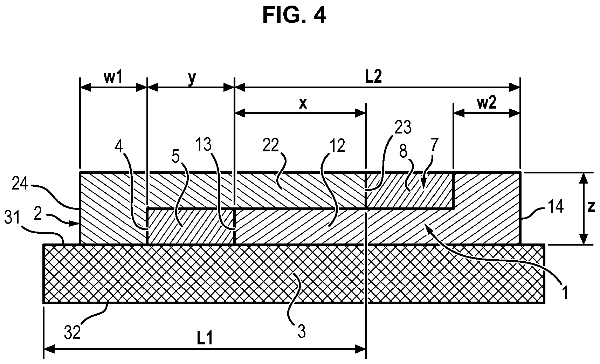

La **figure 4** illustre un thermocouple selon un troisième mode de réalisation selon l'invention. En plus des caractéristiques du deuxième mode de réalisation, le deuxième espace libre 7 est rempli d'un matériau diélectrique 8 identique à celui qui remplit le premier espace libre 4. Le fait de remplir les deux espaces libres définis par les bras 1, 2 permet d'avoir une bonne stabilité mécanique de la structure : la structure est compacte et monobloc et la structure du bras 2 n'est pas en suspension. De plus, un vide pourrait causer une accumulation d'eau ou d'autres éléments gênants, qui par exemple corroderait les bras, causeraient un court-circuit non-désiré entre les bras. Le remplissage de l'espace 7 permet également de « lisser » la structure et éviter par exemple, l'accrochement du flux aérodynamique et la création de tourbillons (vortex) qui dégradent la performance des équipements aéronautiques, dans le cadre d'une application aéronautique.

### Quatrième mode de réalisation

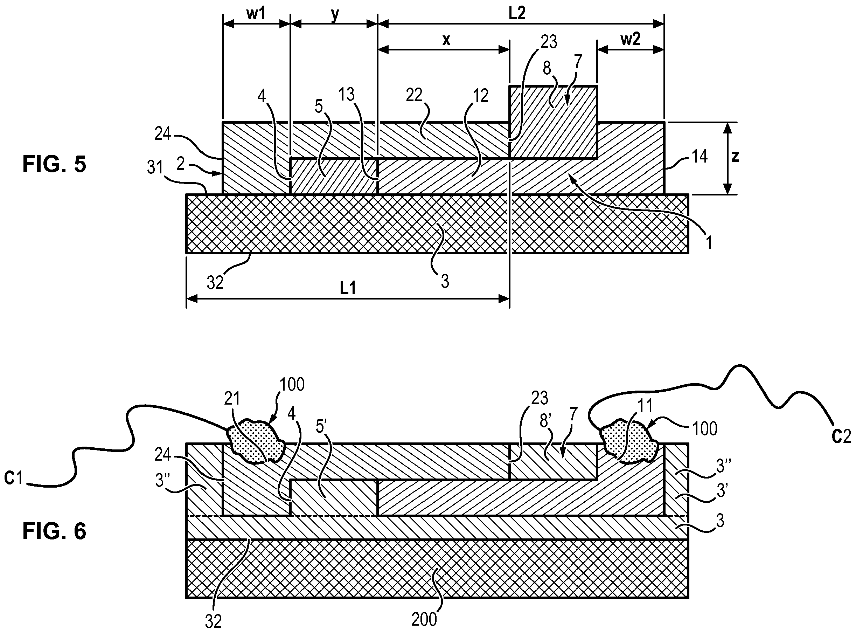

La **figure 5** illustre un thermocouple selon un quatrième mode de réalisation qui reprend toutes les caractéristiques du deuxième mode de réalisation en ayant toutefois le matériau diélectrique 8 qui remplit le deuxième espace libre 7 qui dépasse en hauteur vue de côté de l'épaisseur des bras 1, 2. Un tel dépassement permet d'empêcher la colle 9 autour de s'étaler, le matériau diélectrique agissant comme une barrière qui pourrait causer un connecter entre eux les deux bras, la colle étant conductrice. En effet, lorsqu'un opérateur applique la colle, il risque de l'étaler trop et de court-circuiter ainsi les deux bras. Le matériau 8 qui dépasse permet d'éviter cela.

### Cinquième mode de réalisation

La **figure 6** illustre un thermocouple selon un cinquième mode de réalisation qui est similaire au deuxième mode de réalisation et pour lequel les premier et deuxième bras 11, 21 sont noyés dans un matériau isolant référencé par 3' sur la figure 6 formé du substrat 3, des matériaux diélectriques 5', 8' disposés dans espaces libres 4, 7 ainsi que par des parties latérales 3" qui entourent les bras 1, 2 en s'étendant depuis le substrat 3.

Selon ce mode de réalisation, le thermocouple peut donc être noyé dans la couche d'oxyde ou barrière thermique du support tel qu'une aube ou bien directement dans le diélectrique d'un circuit électronique.

En outre, selon ce mode de réalisation, l'avantage principal réside dans la facilité d'intégration du thermocouple au sein de la couche d'oxyde ou barrière thermique. Ceci permet de rendre l'ensemble compact, fin, miniature et non-intrusif. Ceci permet aussi de réduire les câblages, la masse des composants afin d'améliorer les performances d'une carte électronique et faire de la surveillance (en anglais, monitoring) dans le cas d'une aube de turbomachine.

### Procédés de fabrication

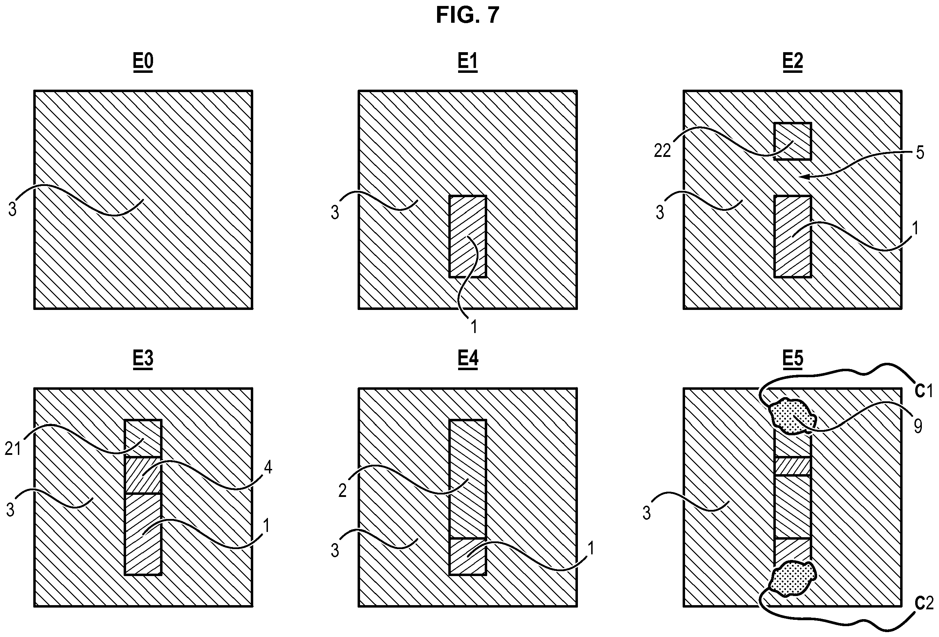

Un procédé de fabrication d'un thermocouple selon les premier, deuxième, troisième et quatrième modes de réalisation est maintenant décrit en relation avec la **figure 7****.**

Dans une étape préliminaire (étape E0) on prend un substrat et on prépare la face supérieure 31 qui va recevoir les bras 1, 2 du thermocouple. Une telle étape est mise en oeuvre par des techniques connues telle que l'activation par plasma, nettoyage, polissage etc. Dans tous les cas, il est assuré que la surface est électriquement isolante.

Ensuite, le premier bras 1 est déposé (étape E1) par des séquences de dépôts bien connus. Il peut s'agir de procédé de lithographie ou d'impression d'encres fonctionnelles, suivie d'un frittage pour retirer les composantes organiques de l'encre, souder les particules métalliques de l'encre entre elles et former ainsi une piste conductrice continue. Le premier bras 1 est déposé jusqu'à une hauteur désirée sur la face supérieure 31 du substrat 2.

Puis, une partie du deuxième bras 2 est déposé (étape E2). Il s'agit de la deuxième borne de connexion 21. Cette borne 21 est déposée jusqu'à la hauteur désirée sur la face supérieure 31 du substrat c'est-à-dire jusqu'à la même hauteur que le premier bras 1. La même technique de dépôt que le premier bras 1 est utilisée.

Selon qu'on fabrique le thermocouple avec ou sans espace libre (premier mode de réalisation vs deuxième ou troisième ode de réalisation) on prévoit le premier espace libre 4 et ainsi entre la deuxième borne de connexion 21 et le premier bras 2 est ensuite déposé le matériau diélectrique 5 dans le premier espace libre 4 (étape E3). Le matériau diélectrique 5 est déposé jusqu'à la même hauteur que la deuxième borne de connexion 21 d'une part et jusqu'à la même hauteur que le premier bras 1.

Ensuite, la partie horizontale 22 du deuxième bras 2 est déposée afin de réaliser la jonction chaude tout en laissant un espace libre 7 entre la première borne de connexion 11 et le deuxième bras 2 (étape E4).

Enfin les fils de connexion C1, C2 sont connectés aux bornes de connexion 11, 21 (étape E5). Une telle connexion par exemple mise en oeuvre au moyen de colle 9 (type pate conductrice à base d'argent) ou par soudage.

De manière alternative, le matériau diélectrique 5 dans le premier espace libre peut être déposé avant le deuxième bras 2. L'intérêt de déposer d'abord le matériau diélectrique permet d'utiliser une résine qui supporte les hautes températures nécessaires pour déposer le deuxième bras 2 par frittage par exemple.

Pour déposer les différents éléments plusieurs techniques sont possibles.

Les procédés de dépôt dits « d'impression » à base d'encres fonctionnelles de matériaux métalliques et / ou diélectriques par des procédés type inkjet (jet d'encre), aérosol jet, sérigraphie (en anglais, screen printing), microextrusion (en anglais, dispensing). Un frittage à plus haute température peut aussi être utilisé (à minima à la température d'opération), qui assure le soudage des particules métalliques entre elles et la formation d'une piste conductrice continue.

D'autres procédés comme le thermal spray peuvent être utilisés. Cette méthode consiste à projeter de la matière chaude qui, en impactant le substrat, se refroidit instantanément et se solidifie. Des masques sont nécessaires pour définir les structures désirées sur le substrat.

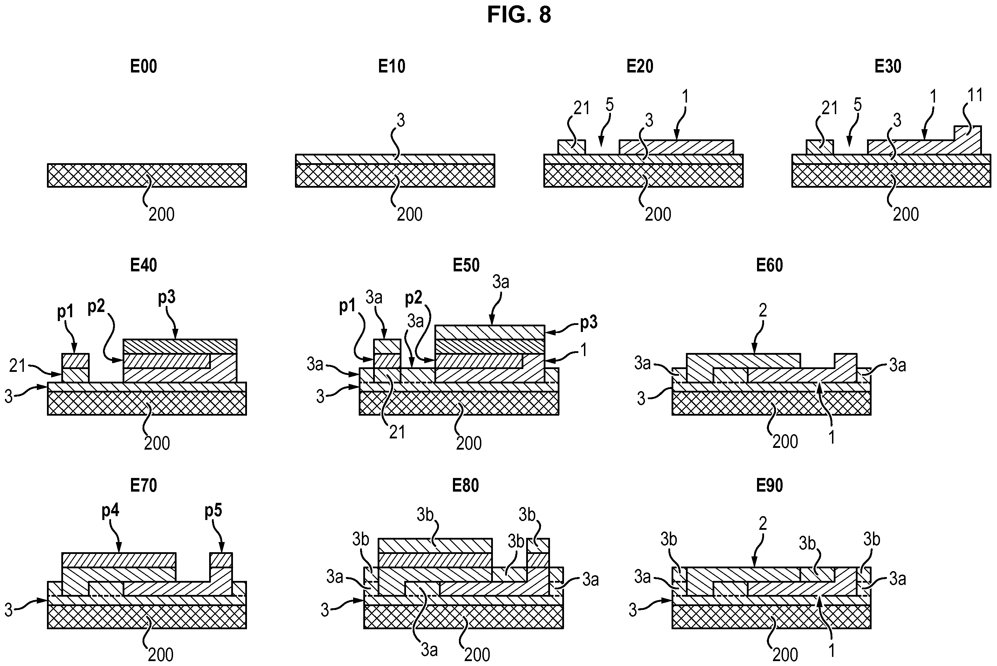

Un procédé de fabrication d'un thermocouple selon le cinquième mode de réalisation de l'invention est maintenant décrit en relation avec la **figure 8****.**

On prévoit un support, par exemple l'aube 200 d'une turbomachine (étape E00).

Le substrat 3 en matériau électriquement isolant est déposé sur le support 200 (étape 10).

Ensuite on procède aux dépôts du premier bras 1 puis d'une partie du deuxième bras 2 formant la borne de connexion 21 (étape E20). Ces dépôts ainsi que les suivants sont mis en oeuvre par des séquences de dépôts bien connus. Il peut s'agir de procédé de lithographie ou d'impression d'encres fonctionnelles, suivie d'un frittage pour retirer les composantes organiques de l'encre, souder les particules métalliques de l'encre entre elles et former ainsi une piste continue. Le premier bras 1 et cette partie du deuxième bras 2 sont déposées jusqu'à une hauteur désirée sur la face supérieure 31 du substrat 3.

La borne de connexion 11 du premier bras 1 est ensuite déposée (étape E30) à l'extrémité extérieure du premier bras 1.

Puis on procède au dépôt (étape E40) de couches provisoires P1, P2, P3 sur le premier bras 1 : une première couche provisoire P1 sur la borne de connexion 21 du deuxième bras 2, une deuxième couche provisoire P2 sur la partie horizontale 12 du premier bras 1 et une troisième couche provisoire P3 sur la borne de connexion 11 du premier bras 1 et sur la couche P2. Ces couches provisoires P1, P2, P3 sont notamment en résine et nécessitent un séchage ou une cuisson.

Une première étape de masquage consistant à déposer un matériau isolant 3a identique à celui du substrat 3 sur l'ensemble formé après le dépôt des trois couches provisoires P1, P2, P3 première couche provisoire P1 recouvrant la borne de connexion 21 du deuxième bras 2 et sur la troisième couche provisoire P3 (étape E50). Les couches provisoires permettent de protéger les éléments qui forment les bras 1, 2.

Le surplus au-dessus des bras est retiré pour ne laisser du matériau isolant que dans les zones au-dessus du substrat 3 déposé à l'étape E10 et la partie horizontale 22 du deuxième bras 2 déposée (étape E60).

Une deuxième étape de masquage est ensuite mise en oeuvre et consiste à déposer des quatrième et cinquième couche provisoires P4, P5 sur les parties des bras qui ne sont pas destinées à être recouvertes de matériau isolant il s'agit du deuxième bras 2 et de la borne de connexion 11 du premier bras 1.

Des couches de matériau isolant 3b identique à celui du matériau 3, 3a, 3b sont ensuite déposées sur 'l'ensemble formé à l'issue de l'étape E70 (étape E80), puis le masquage ainsi que le surplus du matériau isolant est retiré (étape 90). On obtient alors le thermocouple noyé dans le matériau isolant.

Ensuite, reste à connecter les bornes de connexion sur les bornes de connexion 11, 21 de chacun des bras 1, 2.

### Variantes et type de connexions

On a décrit précédemment des bornes de connexion depuis lesquelles s'étendent des fils de connexions C1, C2.

En particulier, on a décrit que les bornes de connexion sont perpendiculaires aux première et deuxième partie horizontale des premier et deuxième bras 1, 2.

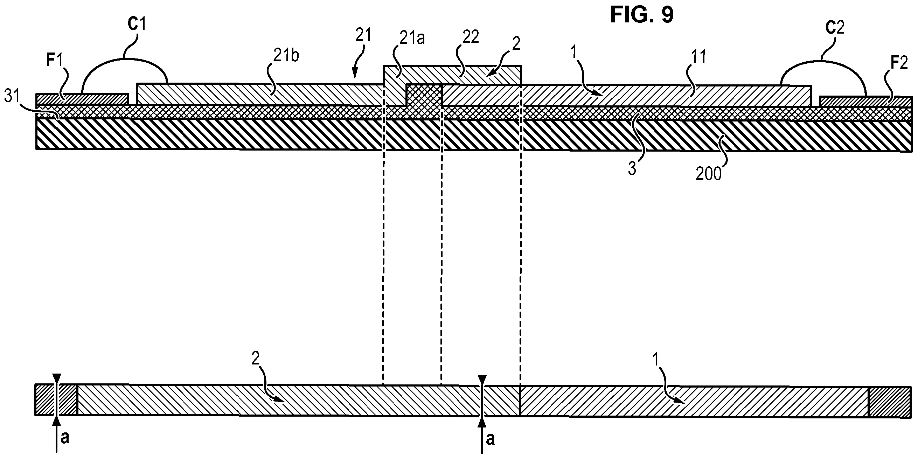

Comme visible sur la figure 9 en vue de côté, et sur la figure 9 en vue de dessus, la deuxième borne de connexion 21 est constituée de deux parties, une partie perpendiculaire 21a à la deuxième partie horizontale 22 et une troisième partie horizontale 21b se prolongeant depuis la deuxième borne de connexion parallèlement à la surface supérieure 31 du substrat 3. En revanche, ici le premier bras comprend une borne de connexion 11 qui est horizontale et qui est dans le prolongement de la première partie horizontale.

Ainsi, les bornes de connexion s'étendent depuis les première et deuxième partie horizontales de chaque bras 1, 2 pour s'éloigner de la jonction chaude et s'approcher le plus possible de la soudure froide. Des fils de connexion C1, C2 connectent les bras aux plots F1, F2 de la soudure froide. Les plots F1, F2 ont la même largeur notée a (en vue de dessus) que les bras 1, 2.

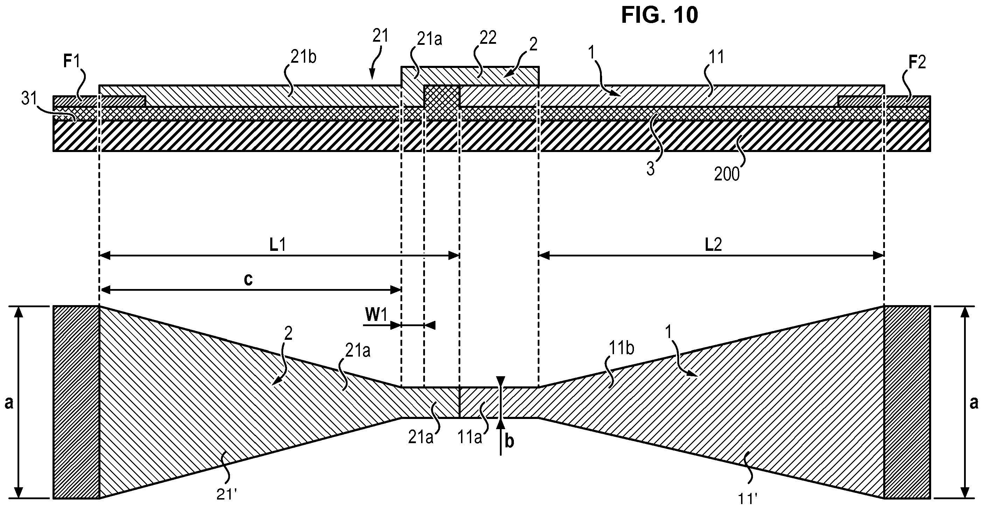

En variante, comme visible sur la figure 10, les bornes de connexions s'étendent aussi sur la surface supérieure du substrat 3 mais ici il n'y pas de fils de connexion, les extrémités des bornes de connexions viennent au contact des plots F1, F2 de la soudure froide.

Également comme cela est visible sur la figure 10 en vue de dessus, les bras s'évasent vers les plots de connexion F1, F2 de la soudure froide et comprennent chacun d'abord une partie rectiligne 11, 21 puis une partie qui s'évase 11', 21'. En particulier, les premier et deuxième bras s'évasent sur une distance notée c à partir des parties 11a, 21a. La largeur des plots F1, F2 est égale à la largeur de la partie la plus évasée des bras 1, 2.

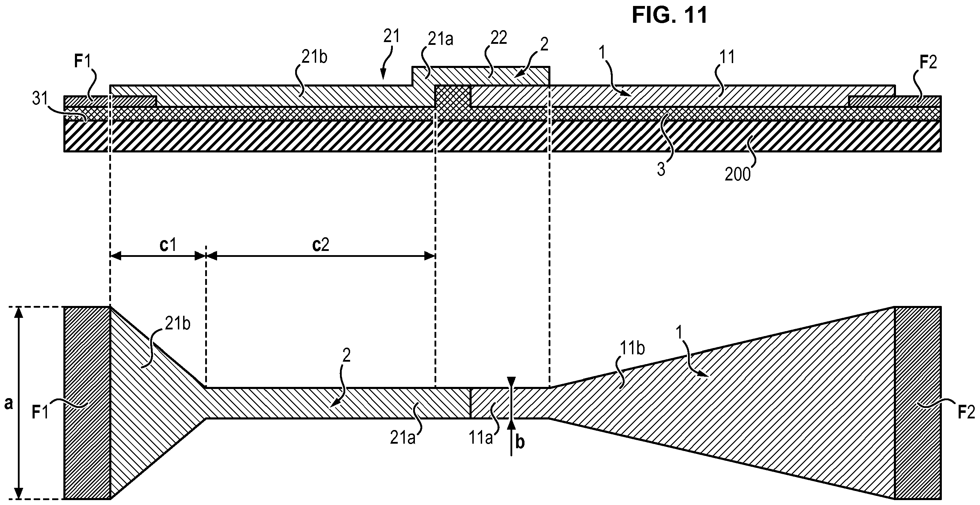

Encore selon une autre variante illustrée sur la figure 11, les bornes de connexion sont d'abord rectilignes et s'évasent ensuite vers les plots de la soudure froide.

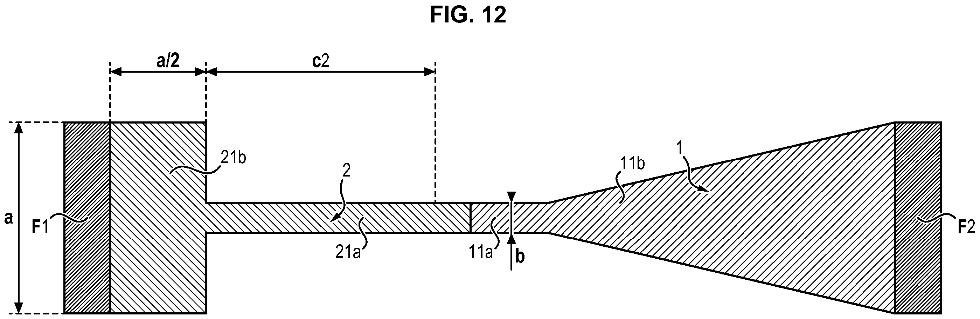

Une autre variante illustrée sur la figure 12 montre qu'un bras 2 comprend une borne de connexion constituée d'une partie rectiligne 21 puis se termine par une partie rectangulaire 21' pour se connecter à un plot de connexion.

On comprend qu'en fonction du type de connexion, les bras peuvent être de formes différentes.

La forme des bras est dictée par l'environnement de connexion du thermocouple. Parfois, il s'agit d'éviter des composants présents dans l'environnement d'intégration du thermocouple.

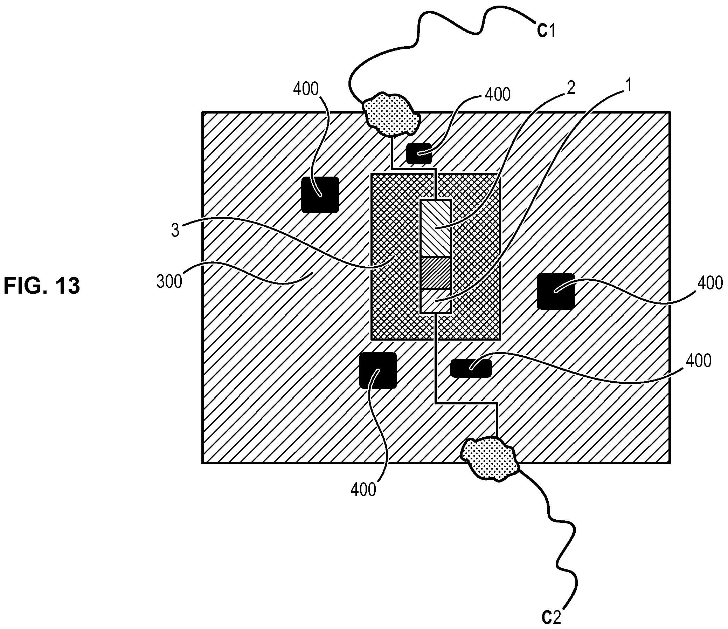

On a illustré sur la figure 13 l'intégration d'un thermocouple. On voit sur cette figure, que les deux bras 1, 2 cheminent par le parcours souhaité sur une plaquette 300. C'est notamment les bornes de connexion qui sont formées pour cheminer sur la plaquette en évitant des composants 400 déjà présents sur la plaquette (matérialisés par des rectangles).

## Revendications

1. Thermocouple comprenant :
- un substrat (3) comprenant une surface supérieure (32) ;
- un premier bras (1) comprenant une première partie horizontale (12) et une première borne de connexion (11) ;
- un deuxième bras (2) comprenant une deuxième partie horizontale (22), comprenant une extrémité interne et une extrémité externe depuis laquelle s'étend une deuxième borne de connexion (21) ;
le premier bras étant disposé sur la surface supérieure (32) du substrat, le deuxième bras étant disposé sur le premier bras (1) de sorte que la deuxième partie horizontale (22) recouvre partiellement la première partie horizontale (12), de manière à définir un premier espace libre (4) entre le substrat (3), le premier bras et le deuxième bras, et de sorte que la deuxième borne de connexion (21) soit en contact avec la partie supérieure (32) du substrat (3), une jonction chaude (6) du thermocouple étant définie par la zone de contact entre le premier bras (1) et le deuxième bras (2), le deuxième bras (2) recouvrant partiellement le premier bras (1) de manière à définir un deuxième espace libre (7) entre la première borne de connexion et l'extrémité interne du deuxième bras, un matériau diélectrique (8) étant disposé dans le deuxième espace libre (7), un matériau diélectrique (5) étant disposé dans le premier espace libre (4).

2. Thermocouple selon la revendication 1, dans lequel le premier bras (1) comprend une extrémité interne et une extrémité externe depuis laquelle s'étend la première borne de connexion (11) depuis le substrat (3).

3. Thermocouple selon l'une des revendications 1 à 2, dans lequel le matériau diélectrique (5, 8) est tel qu'il est isolant dans une gamme de fonctionnement en température dudit thermocouple.

4. Thermocouple selon l'une des revendications 1 à 3, dans lequel le deuxième espace libre (7) présente un volume supérieur au volume du premier espace libre (4).

5. Thermocouple selon l'une des revendications précédentes, dans lequel le substrat (3) est électriquement isolant et de préférence choisi dans le groupe suivant : un revêtement de barrière thermique en zircone yttrie, mono- ou dicilicate d'yttrium ou d'yterbium, alumine, couche d'oxyde d'un superalliage, ou tout autre diélectrique

6. Thermocouple selon l'une des revendications précédentes, dans lequel le premier bras (1) et le deuxième bras (2) sont enveloppés d'un matériau isolant du même matériau que le substrat (3).

7. Procédé de fabrication d'un thermocouple selon l'une des revendications précédentes comprenant les étapes suivantes :
- dépôt (E1, E10) sur un substrat (3) du premier bras (1) ;
- dépôt (E2, E10) sur le substrat (3) de la deuxième borne de connexion (21) du deuxième bras (2) de sorte à laisser un premier espace libre (4) entre le substrat (3), le premier bras (1) et le deuxième bras (2) ;
- dépôt (E4, E60) d'une partie horizontale (22) du deuxième bras (2) depuis la deuxième borne de connexion vers l'intérieur du substrat (3) de manière à recouvrir au moins partiellement le premier bras (1) pour former une jonction chaude (6) du thermocouple.

8. Dispositif de mesure de la température d'une aube de turbomachine, comprenant un thermocouple selon l'une des revendications 1 à 6, le substrat (3) étant disposé sur l'aube.

9. Dispositif de mesure de la température d'une zone déterminée d'un circuit électronique, comprenant un thermocouple selon l'une des revendications 1 à 6, le thermocouple étant agencé dans la zone déterminée de manière à ce que la jonction chaude (6) soit disposée sur la zone déterminée.

## Patentansprüche

1. Thermoelement, umfassend:
- ein Substrat (3), das eine obere Fläche (32) umfasst;
- einen ersten Arm (1), der einen ersten horizontalen Teil (12) und eine erste Anschlussklemme (11) umfasst;
- einen zweiten Arm (2), der einen zweiten horizontalen Teil (22) umfasst, der ein inneres Ende und ein äußeres Ende umfasst, ab dem sich eine zweite Anschlussklemme (21) erstreckt;
wobei der erste Arm auf der oberen Fläche (32) des Substrats angeordnet ist, der zweite Arm auf dem ersten Arm (1) derart angeordnet ist, dass der zweite horizontale Teil (22) den ersten horizontalen Teil (12) teilweise überlappt, um einen ersten Freiraum (4) zwischen dem Substrat (3), dem ersten Arm und dem zweiten Arm zu definieren, und dass die zweite Anschlussklemme (21) mit dem oberen Teil (32) des Substrats (3) in Kontakt ist, wobei eine heiße Verbindung (6) des Thermoelements durch den Kontaktbereich zwischen dem ersten Arm (1) und dem zweiten Arm (2) definiert ist, wobei der zweite Arm (2) den ersten Arm (1) teilweise überlappt, um einen zweiten Freiraum (7) zwischen der ersten Anschlussklemme und dem inneren Ende des zweiten Arms zu definieren, wobei ein dielektrisches Material (8) im zweiten Freiraum (7) angeordnet ist, wobei ein dielektrisches Material (5) im ersten Freiraum (4) angeordnet ist.

2. Thermoelement nach Anspruch 1, wobei der erste Arm (1) ein inneres Ende und ein äußeres Ende umfasst, ab dem sich die erste Anschlussklemme (11) ab dem Substrat (3) erstreckt.

3. Thermoelement nach Anspruch 1 bis 2, wobei das dielektrische Material (5, 8) derart ist, dass es in einem Temperaturbetriebsbereich des Thermoelements isolierend ist.

4. Thermoelement nach Anspruch 1 bis 3, wobei der zweite Freiraum (7) ein Volumen aufweist, das größer als das Volumen des ersten Freiraums (4) ist.

5. Thermoelement nach einem der vorhergehenden Ansprüche, wobei das Substrat (3) elektrisch isolierend ist und vorzugsweise aus der folgenden Gruppe ausgewählt ist: einer Wärmesperrbeschichtung aus yttriumhaltigen Zirkoniumoxid, Yttrium- oder Ytterbiummono- oder -dicyclat, Aluminiumoxid, einer Oxidschicht aus einer Superlegierung oder einem anderen Dielektrikum.

6. Thermoelement nach einem der vorhergehenden Ansprüche, wobei der erste Arm (1) und der zweite Arm (2) mit einem Isoliermaterial aus dem gleichen Material wie das Substrat (3) umhüllt sind.

7. Verfahren zur Herstellung eines Thermoelements nach einem der vorhergehenden Ansprüche, das die folgenden Schritte umfasst:
- Aufbringen (E1, E10) des ersten Arms (1) auf ein Substrat (3);
- Aufbringen (E2, E10) der zweiten Anschlussklemme (21) des zweiten Arms (2) auf das Substrat (3), so dass ein erster Freiraum (4) zwischen dem Substrat (3), dem ersten Arm (1) und dem zweiten Arm (2) verbleibt;
- Aufbringen (E4, E60) eines horizontalen Teils (22) des zweiten Arms (2) ab der zweiten Anschlussklemme in Richtung des Inneren des Substrats (3), so dass der erste Arm (1) mindestens teilweise überlappt wird, um eine heiße Verbindung (6) des Thermoelements zu bilden.

8. Vorrichtung zur Messung der Temperatur einer Turbomaschinenschaufel, die ein Thermoelement nach einem der Ansprüche 1 bis 6 umfasst, wobei das Substrat (3) auf der Schaufel angeordnet ist.

9. Vorrichtung zur Messung der Temperatur eines bestimmten Bereichs eines elektronischen Schaltkreises, umfassend ein Thermoelement nach einem der Ansprüche 1 bis 6, wobei das Thermoelement in dem bestimmten Bereich derart eingerichtet ist, dass die heiße Verbindung (6) auf dem bestimmten Bereich angeordnet ist.

## Claims

1. A thermocouple comprising:
- a substrate (3) comprising an upper surface (32);
- a first arm (1) comprising a first horizontal part (12) and a first connection terminal (11);
- a second arm (2) comprising a second horizontal part (22) comprising an internal end and an external end from which the second connection terminal extends (21) ;
the first arm being arranged on the upper surface (32) of the substrate, the second arm being arranged on the first arm (1) such that the second horizontal part (22) partially overlaps the first horizontal part (12), so as to define a first free space (4) between the substrate (3), the first arm and the second arm, and such that the second connection terminal (21) is in contact with the upper part (32) of the substrate (3), a hot junction (6) of the thermocouple being defined by the zone of contact between the first arm (1) and the second arm (2), the second arm (2) partially overlapping the first arm (1) so as to define a second free space (7) between the first connection terminal and the internal end of the second arm, a dielectric material (8) being arranged in the second free space (7), a dielectric material (5) being arranged in the first free space (4).

2. The thermocouple according to claim 1, wherein the first arm (1) comprises an internal end and an external end from which the first connection terminal (11) extends from the substrate (3).

3. The thermocouple according to claims 1 to 2, wherein the dielectric material (5, 8) is such that it is insulating in a temperature operating range of said thermocouple.

4. The thermocouple according to claims 1 to 3, wherein the second free space (7) has a larger volume than the volume of the first free space (4).

5. The thermocouple according to one of the preceding claims, wherein the substrate (3) is electrically insulating and preferably selected from the following group: a thermal barrier coating made of yttria zirconia, yttrium or yterbium mono- or disilicate, alumina, oxide layer of a superalloy, or any other dielectric.

6. The thermocouple according to one of the preceding claims, wherein the first arm (1) and the second arm (2) are enveloped in an insulating material of the same material as the substrate (3).

7. A method for manufacturing a thermocouple according to one of the preceding claims comprising the following steps:
- depositing (E1, E10) the first arm (1) on a substrate (3);
- depositing (E2, E10) the second connection terminal (21) of the second arm (2) on the substrate (3) so as to leave a first free space (4) between the substrate (3), the first arm (1) and the second arm (2);
- depositing (E4, E60) a horizontal part (22) of the second arm (2) from the second connection terminal towards the inside of the substrate (3) so as to at least partially overlap the first arm (1) to form a hot junction (6) of the thermocouple.

8. A device for measuring the temperature of a turbomachine blade, comprising a thermocouple according to one of claims 1 to 6, the substrate (3) being arranged on the blade.

9. A device for measuring the temperature of a determined zone of an electronic circuit, comprising a thermocouple according to one of claims 1 to 6, the thermocouple being arranged in the determined zone such that the hot junction (6) is arranged on the determined zone.
